# EUROPÄISCHE PATENTANMELDUNG

(11) **EP 4 664 762 A1**
(43) Veröffentlichungstag der Anmeldung: **17.12.2025**
(21) Anmeldenummer: 25161802.1
(22) Anmeldetag: 05.03.2025
(51) Int. Cl.: H03K 17/965

(54) **BEDIENVORRICHTUNG FÜR KRAFTFAHRZEUGE**

(30) Priorität: 12.06.2024 DE 102024116472
(71) Anmelder: HUF Hülsbeck & Fürst GmbH & Co. KG, 42551 Velbert (DE)
(72) Erfinder: WITTE, Martin, 48683 Ahaus (DE); VAN GASTEL, Peter, 42699 Solingen (DE); JOSEPH, Jobish, 42553 Velbert (DE); IONESCU, Andrei, 42551 Velbert (DE)
(74) Vertreter: Zenz Patentanwälte Partnerschaft mbB

(57) **Zusammenfassung**

Eine Bedienvorrichtung (1; 11) für Kraftfahrzeuge. Die Bedienvorrichtung umfasst ein Gehäuse (2; 20) mit einem Betätigungsabschnitt (2a, 2b; 12) an der Außenseite. Eine Sensoreinrichtung (5a, 5b, 4a, 4b; 15a, 15b) ist integriert, welche eine elektronische Detektionsschaltung (5a, 4a; 15a) und ein davon getrenntes metallisches Referenzbauteil (5b, 4b; 15b) enthält. Beide Komponenten sind galvanisch entkoppelt. Die Detektionsschaltung (5a, 4a; 15a) erzeugt ein Abstandssignal, das von dem Abstand zwischen Detektionsschaltung und Referenzbauteil abhängt.

Eine Auswerteeinrichtung (6; 16) erzeugt in Abhängigkeit des Abstandssignals ein Bediensignal, wenn das Abstandssignal einen gespeicherten Betätigungsschwellwert übersteigt. Zusätzlich erfasst die Auswerteeinrichtung (6; 16) eine Temperaturinformation und passt den Betätigungsschwellwert basierend auf dieser Temperaturinformation an.

## Beschreibung

Die Anmeldung betrifft eine Bedienvorrichtung für Kraftfahrzeuge. Insbesondere betrifft die Anmeldung eine Bedienvorrichtung für Kraftfahrzeuge, die mit einem Gehäuse ausgebildet ist, das einen zur Außenseite des Gehäuses gerichteten Betätigungsabschnitt aufweist.

Die Bedienvorrichtung ist derart ausgebildet, dass eine Krafteinwirkung auf den Betätigungsabschnitt an dem Gehäuse erfasst wird. Hierzu ist in der Bedienvorrichtung eine Sensoreinrichtung angeordnet, die eine elektronische Detektionsschaltung aufweist. Diese elektronische Detektionsschaltung weist Bauteile und Komponenten auf, die Signale erzeugen, und über Signalleitungen ausgeben können. Getrennt von der Detektionsschaltung ist als Bestandteil der Sensoreinrichtung ein metallisches Referenzbauteil an der Bedienvorrichtung angeordnet. Das metallische Referenzbauteil ist von der Detektionsschaltung beabstandet und beide Teile, Detektionsschaltung und Referenzbauteil, sind galvanisch voneinander entkoppelt. Das Referenzbauteil und die Detektionsschaltung bilden zusammen die Sensoreinrichtung. Die Detektionsschaltung erzeugt ein Abstandssignal, das vom aktuellen räumlichen Abstand zwischen Detektionsschaltung und Referenzbauteil abhängt. Detektionsschaltung und Referenzbauteil sind in dem Gehäuse der Betätigungseinrichtung so angeordnet, dass eines der Bauteile mit dem Betätigungsabschnitt so gekoppelt ist, dass bei einer Krafteinwirkung auf den Betätigungsabschnitt der Abstand zwischen der Detektionsschaltung und dem zugeordneten Referenzbauteil verändert wird. Hierzu kann das Gehäuse im Betätigungsabschnitt als verformbarer Bereich ausgebildet sein, es können aber auch andere Arten der Beweglichkeit der Detektionsschaltung und des Referenzbauteils relativ zueinander vorgesehen sein. In Betracht kommen z. B. elastisch gegeneinander verschiebbare Gehäuseabschnitte oder Gehäuseteile.

Mit der Detektionsschaltung ist eine Auswerteeinrichtung gekoppelt, die in Abhängigkeit vom Abstandssignal der Detektionsschaltung ein Betätigungssignal erzeugen und ausgeben kann. Dieses Betätigungssignal signalisiert nachgeschalteten Einrichtungen, z. B. einem zugeordneten Fahrzeugsystem, dass eine Betätigung im Bereich des Bedienteils stattgefunden hat. Ist die Bedienvorrichtung z. B. als Türgriff eines Kraftfahrzeugs ausgebildet, kann die nachgeschaltete Einrichtung ein Fahrzeugsystem sein.

Da insbesondere zur Reduzierung von Fehlerdetektionen nur bei gezielten Betätigungen und Krafteinwirkungen auf die Bedienteile tatsächlich Betätigungssignale ausgegeben werden sollen, wird in der Auswerteeinrichtung ein Betätigungsschwellwert gespeichert, der von der Auswerteeinrichtung mit dem jeweils aktuellen Abstandssignal verglichen wird. Überschreitet das Abstandssignal den in der Auswerteeinrichtung gespeicherten Betätigungsschwellwert, kann von einer tatsächlichen Bedienung ausgegangen werden.

Betätigungseinrichtungen der eingangs genannten Art werden in den verschiedensten Varianten an Fahrzeugen eingesetzt. Das Detektionsprinzip beruht dabei auf der Messung einer Abstandsänderung zwischen 2 Bauteilen, die zu einer Signaländerung in einem der Bauteile führt. Insbesondere induktive Sensoren mit einem zugeordneten metallischen Target nutzen dieses Detektionsprinzip. Auch kapazitive Sensoren mit einer zugeordneten metallischen Leiterfläche reagieren auf Abstandsänderungen zwischen den Platten der so gebildeten Kapazität und ermöglichen die Detektion einer
Abstandsänderung.

Aus der EP 3 739 757 A1 ist beispielsweise ein Verfahren zum Betreiben einer Sensoreinrichtung bekannt, die die Verformung eines Betätigungskörpers erfasst.

Auch aus der WO 2020 245 156 A1 ist ein Sensorsystem für bewegliche Teile eines Fahrzeugs bekannt, bei dem ein Bedienelement einen Verformungsbereich aufweist, in dem Bedienhandlungen eines Benutzers detektierbar sind.

Ein Problem der genannten Bedienvorrichtung besteht darin, dass es bei ungünstigen Umgebungsbedingungen zu unerwünschten Fehlbedienungen oder zu einer unerwünschten Unempfindlichkeit der entsprechenden Bedienvorrichtung kommen kann.

Die DE 10 2022 101 197 beschreibt eine induktive Sensoranordnung, die eine Oszillatorschaltung mit einem frequenzgesteuerten Schwingkreis umfasst. Diese Oszillatorschaltung ist mit einer Stromsteuerung gekoppelt, die temperaturabhängig variiert, um die Frequenz der Oszillation zu beeinflussen. Die Stromsteuerung der Oszillatorschaltung wird so angepasst, dass temperaturbedingte Veränderungen der Frequenz ausgeglichen werden.

Der Schaltungsaufwand für diese Lösung ist jedoch erheblich, da insbesondere die Stromsteuerung aus diskreten Bauteilen zu bilden ist.

Aufgabe der Erfindung ist es, eine Bedienvorrichtung mit verbesserter Empfindlichkeit und verringerter Fehleranfälligkeit bereitzustellen.

Diese Aufgabe wird durch eine Bedienvorrichtung mit den Merkmalen des Anspruchs 1 gelöst.

Die erfindungsgemäße Bedienvorrichtung zeichnet sich insbesondere dadurch aus, dass die das Abstandssignal der Detektionsschaltung auswertende Auswerteeinrichtung eine Temperaturinformation erfasst. Die Temperaturinformation gibt die Umgebungsbedingungen hinsichtlich der Temperatur im Bereich der Bedienvorrichtung oder des Fahrzeugs, an dem die Bedienvorrichtung angebracht ist, wieder. Die Auswerteeinrichtung ist so ausgebildet, dass sie in Abhängigkeit von der Temperaturinformation den Betätigungsschwellwert ermittelt und aktualisiert. Der Betätigungsschwellwert ist der Wert, den das Abstandssignal überschreiten muss, um eine tatsächliche Bedienhandlung von Störsignalen oder Fehlbedienungen zu unterscheiden. Es kann vorgesehen werden, dass die Auswerteeinrichtung zusätzliche Kriterien berücksichtigt, z. B. ein Überschreiten des Betätigungsschwellwertes für eine vorgegebene Mindestzeit. In jedem Fall ist es jedoch erforderlich, dass dieser Betätigungsschwellwert überschritten wird. Da es sich bei der detektierten Betätigung um eine Abstandsänderung zwischen der Detektionsschaltung und dem Referenzbauteil, also um eine mechanische Veränderung der Betätigungseinrichtung handelt, ist diese immer von der Temperatur der Betätigungseinrichtung abhängig. Eine identische Krafteinwirkung kann bei unterschiedlichen Temperaturen zu unterschiedlichen Stellwegen führen, insbesondere wenn es sich um die Verformung eines Gehäusebauteils oder eines Schalterbauteils handelt. Bei niedrigen Temperaturen sind die Stellwege bei gleicher Krafteinwirkung in der Regel kleiner, während sie mit steigender Temperatur größer werden. Da Kraftfahrzeuge und deren Bedienvorrichtungen in einem weiten Temperaturbereich, üblicherweise von -40 °C bis +80 °C, fehlerfrei funktionieren müssen, ermöglicht die Anpassung der Betätigungsschwellwerte in Abhängigkeit von der Temperaturinformation durch die Auswerteeinrichtung eine Reduzierung der Fehlbetätigungen bei gleichzeitiger Sicherstellung der gewünschten Empfindlichkeit. Diese Art der Temperaturkompensation bildet dabei die mechanischen Veränderungen in der Betätigungseinrichtung ab, d.h. die Veränderung der Verformung der Betätigungseinrichtung, die zu einer Abstandsänderung zwischen Referenzbauteil und Detektionsschaltung führt. Die elektronischen Komponenten selbst sind in Ihrer Funktion in den genannten Temperaturbereichen deutlich weniger abhängig von der Temperatur der Umgebung.

Die Temperaturinformation selbst kann in der Auswerteeinrichtung selbst erfasst werden, z. B. wenn diese bereits über eine integrierte Temperaturmessung verfügt. Alternativ kann die Temperaturinformation auch von separaten Temperaturfühlern oder -systemen übernommen werden. Die Anpassung der Betätigungsschwellwerte durch die Auswerteeinrichtung berücksichtigt den Einfluss der Temperatur auf die Abstandsmechanik zwischen Detektionsschaltung und Referenzbauteil. Hierzu können insbesondere experimentell ermittelte Kennlinien in der Auswerteeinrichtung hinterlegt werden. So kann z. B. bei unterschiedlichen Temperaturen mit gleicher Kraft auf den Betätigungsabschnitt eingewirkt werden, um eine temperaturabhängige Kennlinie der Empfindlichkeit zu erzeugen, die von der Auswerteeinrichtung zur Anpassung des Betätigungsschwellwertes aufgrund der Temperaturinformation verwendet wird.

Die so erhaltenen Werte können interpoliert werden oder es kann z.B. ein einfaches Berechnungsmodell durch Anpassung abschnittsweise linearer Funktionen an den Kraft-Temperatur-Zusammenhang für die spätere Berechnung des Betätigungsschwellwerts gebildet werden.

In einer bevorzugten Ausführungsform ist die Sensoreinrichtung als induktiver Sensor ausgebildet, wobei die Detektionsschaltung eine Leiterspule aufweist, deren Induktivität sich in Abhängigkeit vom Abstand der Leiterspule zum Referenzbauteil verändert. Die Verwendung eines induktiven Sensors bietet den Vorteil einer präzisen Erfassung von Abstandsänderungen durch induktive Messung. Induktive Sensoren sind hoch empfindlich gegenüber kleinen Bewegungen und robust gegenüber äußeren Einflüssen wie Schmutz und Feuchtigkeit. Zudem sind sie verschleißfrei, was ihre Langlebigkeit erhöht. Durch den geringen Stromverbrauch und die hohe Zuverlässigkeit sind sie kosteneffizient in der Herstellung und Integration.

In einem weiteren bevorzugten Ausführungsbeispiel ist die Sensoreinrichtung als kapazitiver Sensor ausgebildet, wobei die Detektionsschaltung eine Elektrodenfläche aufweist, deren Kapazität sich in Abhängigkeit vom Abstand der Elektrodenfläche zum Referenzbauteil ändert. Kapazitive Sensoren sind wenig anfällig für elektromagnetische Störungen und bieten Flexibilität bei der Gestaltung der Elektrodenfläche. Kapazitive Sensoren eignen sich besonders für dünne und leichte Bauformen und zeichnen sich durch schnelle Reaktionszeiten aus.

Vorzugsweise ist das Referenzbauteil als Metallfolie, Metallblech oder Metallbeschichtung ausgebildet und am Gehäuse befestigt. Dies ermöglicht eine flexible Anpassung an verschiedene Bauformen und eine kostengünstige Herstellung und Integration.

In einer weiteren Ausführungsform kann die Sensoreinrichtung wenigstens teilweise mit einem Vergussmaterial vergossen sein. Dies bietet den Vorteil eines Schutzes vor Feuchtigkeit und Korrosion sowie einer erhöhten mechanischen Stabilität und Haltbarkeit. Zudem wird die elektrische Isolation verbessert, was die Zuverlässigkeit der Sensoreinrichtung weiter erhöht. Um gesamte Sensoreinrichtung zu schützen, können die Detektionseinrichtung und das Referenzbauteil insgesamt vollständig vergossen sein. Beispielsweise kann mit demselben Vergussmaterial der gesamte Zwischenraum zwischen Detektionseinrichtung und Referenzbauteil vergossen sein. Bei einer Krafteinwirkung auf den Betätigungsabschnitt wird dann eine Verlagerung der Bauteile gegeneinander unter Verformung des Vergussmaterials herbeigeführt. In diesem Fall ist es besonders vorteilhaft, wenn eine Temperaturanpassung des Betätigungsschwellwert des erfolgt, da die Verformbarkeit des Vergussmaterials stark von der Temperatur abhängig ist.

Die Auswerteeinrichtung kann selbst mit einem Temperatursensor ausgestattet sein, der die Temperaturinformation bereitstellt. Dies ermöglicht eine direkte Erfassung der Temperatur in der Umgebung der Bedienvorrichtung und eine kontinuierliche Anpassung der Betätigungsschwellwerte. Alternativ kann die Temperaturinformation über eine Datenverbindung zu einem Fahrzeug erhalten werden. Dies ermöglicht eine zentrale Temperaturerfassung und -verarbeitung.

Die Auswerteeinrichtung kann die den Temperaturinformationen zugeordneten Betätigungsschwellwerte als tabellarische Werte oder als Berechnungsanweisung speichern. Dies bietet Flexibilität bei der Anpassung der Betätigungsschwellwerte an unterschiedliche Temperaturbedingungen.

Die Aktualisierung der Betätigungsschwellwerte kann in vorgegebenen Zeitabständen und/oder bei Veränderung der Temperatur um einen vorgegebenen Temperatur-Änderungswert erfolgen, um eine laufende Anpassung an die aktuellen Umgebungsbedingungen sicherzustellen. Der Temperatur-Änderungswert kann z.B. einige °Celsius, z.B. 5°C oder 10°C betragen, so dass die Anpassung nicht übermäßig häufig durchgeführt wird.

Weiterhin umfasst die Erfindung ein Verfahren zum Betreiben einer Bedienvorrichtung, das die Schritte des Erfassen einer Temperatur mit der Auswerteeinrichtung, das Bestimmen eines Betätigungsschwellwertes in Abhängigkeit von der Temperatur, das Erfassen eines Abstandssignals mit der Sensoreinrichtung und das Ausgeben des Bediensignals mit der Auswerteeinrichtung, wenn das Abstandssignal den Betätigungsschwellwert übersteigt, beinhaltet.

Die Erfindung wird nun anhand der beiliegenden Zeichnung näher erläutert.
Figuren 1a und 1b zeigen in schematischer Weise eine Bedienvorrichtung gemäß einem 1. Ausführungsbeispiel der Erfindung;
Figur 2 zeigt ein Blockschaltbild der Funktionskomponenten einer erfindungsgemäßen Bedienvorrichtung;
Figur 3 zeigt beispielhaft einen abschnittsweise linearen funktionalen Zusammenhang zwischen Temperatur und Betätigungsschwellwert;

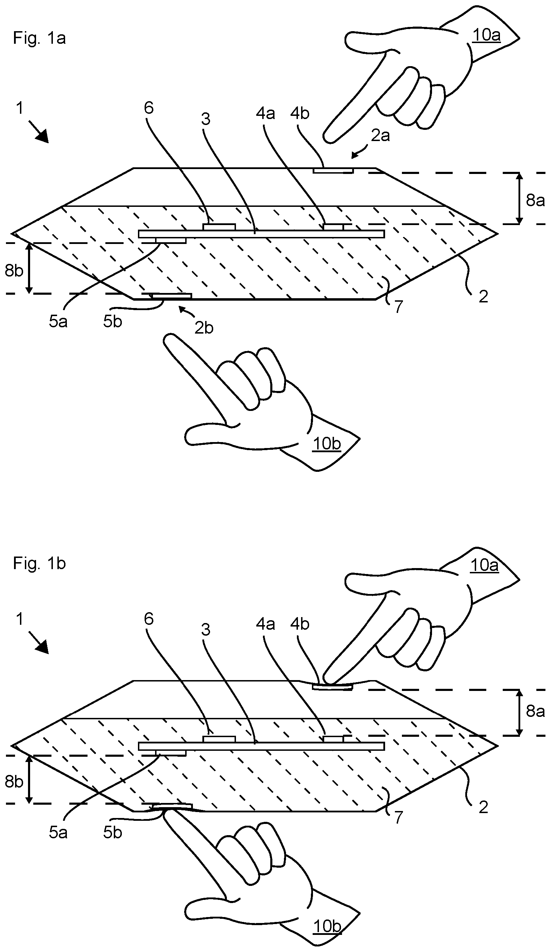

Die Figuren 1a und 1b zeigen eine Bedienvorrichtung 1 gemäß einem ersten Ausführungsbeispiel in schematischer Ansicht. In einem Gehäuse 2 sind Komponenten der Bedienvorrichtung 1 untergebracht und gegenüber der Umgebung gekapselt. Das Gehäuse 2 kann eine beliebige Form und ein beliebiges Material aufweisen. Es kann eine innerhalb oder außerhalb des Fahrzeugs angeordnete Bedieneinrichtung sein. Beispielsweise kann das Gehäuse 2 in seiner Gestaltung einem Fahrzeugtürgriff entsprechen, an den ein Benutzer herantritt und ihn ergreift, um die Fahrzeugtür zu öffnen oder andere Bedienhandlungen am Fahrzeugtürgriff vorzunehmen.

Figur 1 zeigt die Bedieneinrichtung 1 in einem unbedienten Zustand. Dies wird dadurch symbolisiert, dass die Hände 10a und 10b, die den Zugriff eines Benutzers symbolisieren, beabstandet zu dem Gehäuse 2 angeordnet sind. In dem Gehäuse 2 ist eine Platine 3 angeordnet, die von einem Vergussmaterial 7 umgeben ist. Auf der Platine 3 ist eine Auswerteeinrichtung 6 in Form eines Mikrocontrollers angeordnet. Weiterhin sind auf der Platine 3 Detektionsschaltungen 4a und 5a angeordnet, die mit der Auswerteeinrichtung 6 zur Auswertung gekoppelt sind. Die Detektionsschaltungen 4a und 5a weisen jeweils Spulen und gegebenenfalls weitere Bauelemente zur Bildung von Schwingkreisen auf. Die Auswertung der Induktivitäten der Spulen ist ein bekanntes Verfahren und wird hier nicht näher erläutert. Den Detektionsschaltungen 4a und 5a sind jeweils Referenzbauteile in Form von metallischen Targets 4b bzw. 5b zugeordnet. Diese metallischen Targets sind von den zugehörigen Detektionsschaltungen 4a und 4b durch die Abstände 8a und 8b beabstandet. Die Detektionsschaltung 4a bildet zusammen mit dem metallischen Target 4b eine Detektionseinrichtung. Die Detektionsschaltung 5a bildet zusammen mit dem metallischen Target 5b eine Sensoreinrichtung. Es ist ersichtlich, dass die metallischen Targets 4b und 5b mit dem Gehäuse 2 gekoppelt sind, indem sie als metallischer Gegenstand an dessen Innenseite befestigt, insbesondere verklebt sind. Dies bewirkt, dass bei Verformung des Gehäuses 2 in dem Bereich, in welchem die metallischen Targets 4b und 5b angeordnet sind, diese metallischen Targets 4b und 5b als metallische Referenzbauteile relativ zu den zugeordneten Detektionsschaltungen 4a und 5b verlagert werden. Findet eine solche Verlagerung statt, ändert sich die Induktivitäten der Spulen in den Detektionsschaltung und 4a und 5a. Diese Änderung der Induktivitäten wird in der Auswerteeinrichtung 6 als Abstandssignal erfasst. Übersteigt diese Änderung des Abstandssignals einen Vorgehen gegebenen Betätigungsschwellwert, so löst die Auswerteeinrichtung 6 aus, zeigt also einen Bedienvorgang an. Dies geschieht, indem die Auswertungseinrichtung 6 an einem Signalausgang ein entsprechendes Betätigungssignal angelegt. Der Betätigungsschwellwert wird jedoch in der Auswertungseinrichtung 6 in Abhängigkeit von der jeweils aktuellen Temperatur bestimmt.

Der Mikrocontroller, der Bestandteil der Auswerteeinrichtung 6 ist, verfügt über eigene FunktionsKomponenten zur Temperaturerfassung, so dass die Auswerteeinrichtung 6 auf diese Temperaturerfassungsdaten zurückgreifen kann, um eine aktuelle Betätigungsschwelle zu bestimmen. In diesem Ausführungsbeispiel ist die Auswerteeinrichtung derart ausgebildet, dass sie die Auslöseschwelle periodisch, z. B. minütlich, aktualisiert.

In Abbildung 1b ist der Betätigungsfall für die Betätigungseinrichtung 1 dargestellt. Die Hände 10a und 10b wirken jeweils in Bereichen auf das Gehäuse 2 ein, in denen die metallischen Targets 4b und 5b angeordnet sind.

Es ist beispielhaft dargestellt, dass die Hände 10a und 10b jeweils mit gleicher Kraft auf das Gehäuse 2 einwirken. Die Verformung des Gehäuses im Bereich des metallischen Targets 4b ist jedoch bei gleicher Krafteinwirkung größer als in dem Gehäuseabschnitt, in dem das metallische Target 5b angeordnet ist. Dies liegt daran, dass das Gehäuse 2 im Bereich des metallischen Targets 5b durch das Vergussmaterial 7 verstärkt ist und die Verformung daher geringer ausfällt. Dementsprechend sind in der Auswerteeinrichtung 6 für die unterschiedlichen Detektionsschaltungen 5a und 4a, insbesondere für die von diesen Detektionsschaltungen gelieferten Abstandswerte, unterschiedliche Betätigungsschwellwerte hinterlegt. Diese werden aufgrund der unterschiedlichen Reaktion auf Krafteinwirkungen jeweils mit den aktuellen Temperaturdaten aktualisiert. Die Abhängigkeit der Betätigungsschwellwerte für jede der Erfassungseinrichtungen 4a und 5a von einer Temperatur kann in diesem Zusammenhang empirisch ermittelt werden, indem auf ein Exemplar der Betätigungseinrichtung 1 unter Variation der Temperatur mit gleicher Kraft eingewirkt wird und der Verlauf der jeweiligen Abstandssignale aufgezeichnet wird. Aus einem solchen Verlauf können in der Auswerteeinrichtung 6 Betätigungsschwellwerte interpoliert werden.

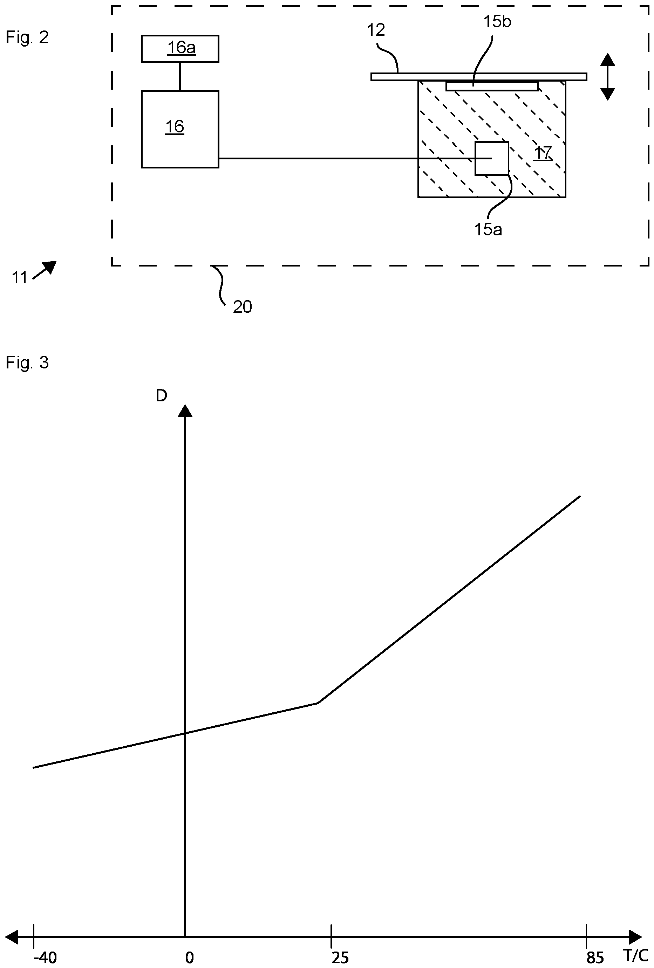

Figur 2 zeigt schematisch die Funktionskomponenten einer erfindungsgemäßen Betätigungsvorrichtung.

Eine Auswerteeinrichtung 16 ist mit einer Temperaturerfassung 16a gekoppelt, um aktuelle Temperaturwerte zu erfassen. Die Auswerteeinrichtung 16 ist weiterhin mit der Detektionsschaltung 15a gekoppelt, die Abstandssignale liefert. Diese Abstandssignale ändern sich in Abhängigkeit vom Abstand der Detektionsschaltung 15a zu dem metallischen Target 15b, das als Referenzbauteil an einem Gehäuse 12 einer Bedieneinrichtung befestigt ist. Das metallische Target 15b und die zugeordnete Detektionsschaltung 15a sind gemeinsam von einem Vergussmaterial 17 umgeben, das den Abstand dieser Bauteile zueinander fixiert.

Die Verformbarkeit des Vergussmaterials 17 sowie des Gehäuses 12 hängt wesentlich von der Temperatur ab.

Die Auswerteeinrichtung 16 passt dementsprechend die Betätigungsschwellwerte, bei deren Überschreitung durch die Abstandssignale der Detektionseinrichtung 15a auf einen Betätigungsvorgang geschlossen wird, in Abhängigkeit von der Temperatur an, welche durch die Temperaturerfassung 16a detektiert wird.

Figur 3 zeigt beispielhaft einen abschnittsweise linearen funktionalen Zusammenhang zwischen einer Temperatur und einem Abstandssignal (hier vereinfacht in einer unspezifischen Einheit von Digits dargestellt) bei konstanter Krafteinwirkung. Eine solche abschnittsweise lineare Funktion erlaubt eine einfache Berechnung der Temperaturabhängigkeit der Ansprechschwelle in Abhängigkeit von einer erfassten Temperatur. Stützstellen für die Berechnung eines solchen linearen Zusammenhangs werden, wie oben beschrieben, durch Betätigung einer aus konstruierten Betätigungsvorrichtung in Abhängigkeit von verschiedenen Betriebstemperaturen bei gleicher Krafteinwirkung ermittelt.

## Patentansprüche

1. Bedienvorrichtung (1; 11) für Kraftfahrzeuge, wobei die Bedienvorrichtung ein Gehäuse (2; 20) mit einem Betätigungsabschnitt (2a, 2b; 12) an der Außenseite des Gehäuses (2; 20) aufweist,
wobei die Bedienvorrichtung (1; 11) ausgebildet ist, um eine Krafteinwirkung auf den Betätigungsabschnitt (2a, 2b; 12) zu erfassen, mit
einer Sensoreinrichtung (5a, 5b, 4a, 4b; 15a, 15b), wobei die Sensoreinrichtung (5a, 5b, 4a, 4b; 15a, 15b) eine elektronische Detektionsschaltung (5a, 4a; 15a) und ein von der Detektionsschaltung getrenntes und beabstandetes metallisches Referenzbauteil (5b, 4b; 15b) aufweist,
wobei die Detektionsschaltung (5a, 4a; 15a) und das Referenzbauteil (5b, 4b; 15b) voneinander galvanisch entkoppelt sind,
wobei die Detektionsschaltung (5a, 4a; 15a) ausgebildet ist, ein Abstandssignal zu erzeugen, welches von dem räumlichen Abstand zwischen Detektionsschaltung (5a, 4a; 15a) und Referenzbauteil (5b, 4b; 15b) abhängt,
wobei eine Auswerteeinrichtung (6; 16) vorgesehen ist, welche ausgebildet ist, in Abhängigkeit von dem Abstandssignal ein Bediensignal zu erzeugen und auszugeben,
wobei die Auswerteeinrichtung (6; 16) ausgebildet ist, das Bediensignal dann auszugeben, wenn das Abstandssignal einen gespeicherten Betätigungsschwellwert übersteigt,
**dadurch gekennzeichnet,**
**dass** die Auswerteeinrichtung (6; 16) ausgebildet ist, eine Temperaturinformation zu erfassen,
wobei die Auswerteeinrichtung (6; 16) ausgebildet ist, den Betätigungsschwellwert in Abhängigkeit von der Temperaturinformation zu bestimmen und zu aktualisieren.

2. Bedienvorrichtung nach Anspruch 1, wobei die Sensoreinrichtung (5a, 5b, 4a, 4b; 15a, 15b) als induktiver Sensor ausgebildet ist, wobei die Detektionsschaltung (5a, 4a; 15a) eine Leiterspule aufweist, deren Induktivität sich in Abhängigkeit des Abstands der Leiterspule zu dem Referenzbauteil (5b, 4b; 15b) verändert.

3. Bedienvorrichtung nach Anspruch 1, wobei die Sensoreinrichtung als kapazitiver Sensor ausgebildet ist, wobei die Detektionsschaltung eine Elektrodenfläche aufweist, deren Kapazität sich in Abhängigkeit des Abstands der Elektrodenfläche vom Referenzbauteil verändert.

4. Bedienvorrichtung nach Anspruch 2 oder 3, wobei das Referenzbauteil (5b, 4b; 15b) als Metallfolie oder als Metallblech oder als Metallbeschichtung ausgebildet und an dem Gehäuse befestigt ist.

5. Bedienvorrichtung nach einem der vorangehenden Ansprüche, wobei in dem Gehäuse (2; 20) der Bedienvorrichtung die Sensoreinrichtung (5a, 5b, 4a, 4b; 15a, 15b) wenigstens teilweise mit einem Vergussmaterial (7; 17) vergossen ist.

6. Bedienvorrichtung nach einem der vorangehenden Ansprüche, wobei die Auswerteeinrichtung (6) mit einem Temperatursensor ausgebildet ist, welcher die Temperaturinformation bereitstellt.

7. Bedienvorrichtung nach einem der vorangehenden Ansprüche, wobei die Detektionsschaltung (5a, 5a) der Sensoreinrichtung und die Auswerteeinrichtung (6) auf derselben Platine (3) angeordnet und gekoppelt sind.

8. Bedienvorrichtung nach einem der vorangehenden Ansprüche, wobei in der Auswerteeinrichtung den Temperaturinformationen zugeordnete Betätigungsschwellwerte als tabellarische Werte oder als Berechnungsanweisung gespeichert sind.

9. Bedienvorrichtung nach einem der vorangehenden Ansprüche, wobei die Auswerteeinrichtung ausgebildet ist, die Temperaturinformation ausschließlich oder zusätzlich über eine Datenverbindung zu einem Fahrzeug zu erhalten.

10. Bedienvorrichtung nach einem der vorangehenden Ansprüche, wobei die Auswerteeinrichtung ausgebildet ist, den Betätigungsschwellwert in vorgegebenen Zeitabständen und/oder bei Veränderung der Temperatur, um einen vorgegebenen Temperatur-Änderungswert zu aktualisieren.

11. Verfahren zum Betreiben einer Bedienvorrichtung mit den Merkmalen eines der vorangehenden Ansprüche, mit den Schritten:
- Erfassen einer Temperatur mit der Auswerteeinrichtung;
- Bestimmen eines Betätigungsschwellwertes in Abhängigkeit von der Temperatur;
- Erfassen eines Abstandssignals mit der Sensoreinrichtung;
- Ausgeben des Bediensignals mit der Auswerteeinrichtung, wenn das Abstandssignal den Betätigungsschwellwert übersteigt.
